(19) Europäisches Patentamt / European Patent Office / Office européen des brevets

(11) **EP 2 521 184 A2**

(12) **EUROPEAN PATENT APPLICATION**

(43) Date of publication:
**07.11.2012 Bulletin 2012/45**

(51) Int Cl.:
**H01L 31/028** (2006.01)    **H01L 31/076** (2012.01)

(21) Application number: **12162318.5**

(22) Date of filing: **30.03.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **04.05.2011 KR 20110042707**

(71) Applicants:
- **Samsung SDI Co., Ltd.**
  **Yongin-si, Gyeonggi-do (KR)**
- **Samsung Electronics Co., Ltd.**
  **Suwon-si, Gyeonggi-do, 443-742 (KR)**

(72) Inventors:
- **Jung, Seung-Jae**
  **Gyeonggi-do (KR)**
- **Nam, Yuk-Hyun**
  **Gyeonggi-do (KR)**
- **Jeon, Ki-Won**
  **Gyeonggi-do (KR)**

(74) Representative: **Mounteney, Simon James**
**Marks & Clerk LLP**
**90 Long Acre**
**London**
**WC2E 9RA (GB)**

(54) **Photoelectric conversion device**

(57)    A photoelectric conversion device (100) includes a first photoelectric conversion unit (20) on a substrate (10) and having a first energy bandgap, a second photoelectric conversion unit (40) having a second energy bandgap that is different from the first energy bandgap, the second photoelectric conversion unit being on the first photoelectric conversion unit, and an intermediate unit (30) between the first and second photoelectric conversion units, the intermediate unit including a stack of a first intermediate layer (31) and a second intermediate layer (32), each of the first intermediate layer and the second intermediate layer having a refractive index that is smaller than that of the first photoelectric conversion unit, the first intermediate layer having a first refractive index, and the second intermediate layer having a second refractive index that is smaller than the first refractive index.

FIG. 1

EP 2 521 184 A2

**Description**

BACKGROUND

1. Field

The present invention relates to a photoelectric conversion element and a photoelectric conversion device.

2. Description of the Related Art

A photoelectric conversion device comprises an element converting light energy to electric energy. The photoelectric conversion element may absorb energy from light and generate a free electron by a photoelectric effect to thereby generate a current. The photoelectric efficiency of the photoelectric conversion device may be determined by the amount of current output from the photoelectric conversion element compared to the amount of light supplied to the photoelectric conversion element.

The above information disclosed in this Background section is only for enhancement of understanding of the background of the described technology and therefore it may contain information that does not form the prior art that is already known in this country to a person of ordinary skill in the art.

The present invention sets out to provide a photo electric device having an improved photoelectric efficiency relative to the prior art.

SUMMARY

Accordingly, the invention provides a photoelectric conversion element, including a first photoelectric conversion unit on a substrate and having a first energy bandgap, a second photoelectric conversion unit having a second energy bandgap that is different from the first energy bandgap, the second photoelectric conversion unit being on the first photoelectric conversion unit, and an intermediate unit between the first and second photoelectric conversion units, the intermediate unit including a stack of a first intermediate layer and a second intermediate layer, each of the first intermediate layer and the second intermediate layer having a refractive index that is smaller than that of the first photoelectric conversion unit, the first intermediate layer having a first refractive index, and the second intermediate layer having a second refractive index that is smaller than the first refractive index.

The intermediate unit may include at least one first intermediate layer in the stack, and may include at least one second intermediate layer alternately arranged with the first intermediate layer in the stack.

The first intermediate layer may have an electrical conductivity that is higher than that of the second intermediate layer.

The first and second intermediate layers may be doped with an n-type or p-type impurity, and concentrations of the n-type and p-type impurities in the first and second intermediate layers may be respectively less than 1 at%.

The first and second intermediate layers may be doped with an n-type or p-type impurity, and two n-type first intermediate layers may be respectively disposed at outermost sides of the intermediate unit, such that the first photoelectric conversion unit is in direct contact with one of the two n-type first intermediate layers, and the second photoelectric conversion unit is in direct contact with another of the two n-type first intermediate layers.

The first photoelectric conversion unit may include a first intrinsic silicon layer formed of amorphous silicon, a first type conductive layer disposed between the first intrinsic silicon layer and the substrate, and a second type conductive layer provided on the first intrinsic silicon layer, and the second photoelectric conversion unit may include a second intrinsic silicon layer formed of crystalline silicon including a plurality of crystals, a third type conductive layer disposed between the second intrinsic silicon layer and the intermediate unit, and a fourth type conductive layer provided on the second intrinsic silicon layer.

The first and second intermediate layers may be doped with an n-type or p-type impurity, and an n-type first intermediate layer and a p-type first intermediate layer may be respectively disposed at outermost sides of the intermediate unit, the first photoelectric conversion unit being in direct contact with one of the n-type first intermediate layer and the p-type first intermediate layer, and the second photoelectric conversion unit being in direct contact with another of the n-type first intermediate layer and the p-type first intermediate layer.

The first photoelectric conversion unit may include a first intrinsic silicon layer formed of amorphous silicon and contacting the n-type first intermediate layer, and the second photoelectric conversion unit may include a second intrinsic silicon layer formed of crystalline silicon including a plurality of crystals and contacting the p-type first intermediate layer.

The first and second intermediate layers may be doped with an n-type or p-type impurity, and the first and second intermediate layers may include at least one of $SiO_x$:H, $SiC_x$:H, and $SiN_x$:H.

The first intermediate layer may have a refractive index in a range of 2.3 to 3.0 and the second intermediate layer may have a refractive index in a range of 1.6 to 2.1.

The first intermediate layer may have an electrical conductivity of over $10^{-3}$ /Ωcm and the second intermediate layer may have an electrical conductivity of below $10^{-4}$/Ωcm.

The first intermediate layer may have a thickness of 10 Å to 500 Å and the second intermediate layer may have a thickness of 50 Å to 1500 Å.

The first intermediate layer may have an oxygen concentration of below 40 at% and the second intermediate layer may have an oxygen concentration of 40 at% to 70 at%.

The intermediate unit may include k layers, where k is an integer greater than 2, the refractive index of the intermediate unit being defined as $n_a$ according to the following equation,

$$n_a = \frac{(n_1 \times d_1 + n_2 \times d_2 + ... + n_k \times d_k)}{(d_1 + d_2 + ... + d_k)}$$

in which $n_l$ to $n_k$ denote a refractive index of each of the k layers included in the intermediate layer, and $d_l$ to $d_k$ denote a thickness of each of the k layers included in the intermediate unit.

The intermediate unit may have a refractive index of 1.7 to 2.5 and may have a thickness of 100 Å to 1500 Å.

Another embodiment is directed to a photoelectric conversion device, including a substrate having a plurality of cell areas, and a plurality of photoelectric conversion cells on the substrate, respectively corresponding to the plurality of cell areas, the photoelectric conversion cells being coupled in series and each including a first electrode layer on the substrate, a first photoelectric conversion unit on the first electrode layer and having a first energy bandgap, a second photoelectric conversion unit having a second energy bandgap that is different from the first energy bandgap, the second photoelectric conversion unit being above the first photoelectric conversion unit; an intermediate unit between the first and second photoelectric conversion units, the intermediate unit including a stack of a first intermediate layer and a second intermediate layer, the first intermediate layer and the second intermediate layer each having a refractive index that is smaller than that of the first photoelectric conversion unit, the first intermediate layer having a first refractive index, and the second intermediate layer having a second refractive index that is smaller than the first refractive index; and a second electrode layer on the second photoelectric conversion unit.

The first intermediate layer may have an electrical conductivity that is higher than that of the second intermediate layer, and two first intermediate layers may be respectively disposed at outermost sides of the intermediate unit, such that the first photoelectric conversion unit is in direct contact with one of the two first intermediate layers, and the second photoelectric conversion unit is in direct contact with another of the two first intermediate layers.

The first photoelectric conversion unit may include a first intrinsic silicon layer formed of amorphous silicon, a first type conductive layer between the first intrinsic silicon layer and the substrate, and a second type conductive layer on the first intrinsic silicon layer, and the second photoelectric conversion unit may include a second intrinsic silicon layer formed of crystalline silicon including a plurality of crystals, a third type conductive layer between the second intrinsic silicon layer and the intermediate unit, and a fourth type conductive layer on the second intrinsic silicon layer.

The intermediate unit may include k layers, where k is an integer greater than 2, the refractive index of the intermediate unit being defined as $n_a$ according to the following equation,

$$n_a = \frac{(n_1 \times d_1 + n_2 \times d_2 + ... + n_k \times d_k)}{(d_1 + d_2 + ... + d_k)}$$

in which $n_l$ to $n_k$ denote a refractive index of each of the k layers included in the intermediate unit, and $d_l$ to $d_k$ denote a thickness of each of the k layers included in the intermediate unit.

The intermediate unit may have a refractive index of 1.7 to 2.5 and a thickness of 100 Å to 1500 Å.

The first electrode layer may be divided into the cell areas by a first separation groove, and the first and second photoelectric conversion units, the intermediate unit, and the second electrode layer may be divided into the cell areas by a second separation groove.

In each photoelectric conversion cell, a via hole may sequentially penetrate the second photoelectric conversion unit, the intermediate unit, and the first photoelectric conversion unit to expose a first electrode layer of a neighboring photoelectric conversion cell, and the second electrode layer may be electrically connected to the first electrode layer of the neighboring photoelectric conversion cell through the via hole.

A via hole may be provided in a first photoelectric conversion cell of the plurality of photoelectric conversion cells, the via hole sequentially penetrating the second photoelectric conversion unit, the intermediate unit, and the first photoelectric conversion unit of the first photoelectric conversion cell, the via hole exposing a first electrode layer of a second photoelectric conversion cell of the plurality of photoelectric conversion cells, the second photoelectric conversion cell neighboring the first photoelectric conversion cell, and the second electrode layer of the first photoelectric conversion cell may be electrically connected to the first electrode layer of the second photoelectric conversion cell through the via hole.

At least some of the above and other features of the invention are set out in the claims.

BRIEF DESCRIPTION OF THE DRAWINGS

Features of the invention will become apparent to those of skill in the art by referring to the following embodiments of the invention that are described with reference to the attached drawings in which:

FIG. 1 illustrates a photoelectric conversion device according to an embodiment of the invention.

FIG. 2 illustrates a graph of a light absorption rate of first and second photoelectric conversion units according to a wavelength,

FIG. 3 illustrates an enlarged cross-sectional view of a portion R1 in FIG. 1 according to an embodiment of the invention.

FIG. 4 illustrates a graph of variation of a refractive index according to concentration of carbon dioxide.

FIG. 5 illustrates a graph of concentration of oxygen in the layer according to a refractive index.

FIG. 6A to FIG. 6E illustrate graphs of atom concentrations (%) of oxygen ($O_{1s}$), carbon ($C_{1s}$), and silicon ($Si_{2p}$) according to concentration of carbon dioxide ($CO_2$).

FIG. 7 illustrates a graph of oxygen concentration variation when forming an intermediate layer having a triple-layered structured.

FIG. 8 illustrates a cross-sectional view of a structure of an intermediate layer according to a second embodiment of the invention.

FIG. 9A to FIG. 9D illustrate cross-sectional views of photoelectric conversion devices according to other embodiments of the invention.

FIG. 10 illustrates a cross-sectional view of a photoelectric conversion device including a plurality of photoelectric conversion cells according to an embodiment of the invention,

DETAILED DESCRIPTION

Embodiments of the invention will now be described more fully hereinafter with reference to the accompanying drawings; however, the invention may be embodied in different forms and should not be construed as limited to the embodiments set forth herein. Rather, these embodiments are provided so that this disclosure will be thorough and complete, and will fully convey the scope of the invention to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

The terms, 'first', 'second' and the like may be simply used for description of various constituent elements, but those meanings may not be limited to the restricted meanings. The above terms are used only for distinguishing one constituent element from other constituent elements. For example, a first constituent element may be referred to as a second constituent element and similarly, the second constituent element may be referred to as the first constituent element within the scope of the appended claims. When explaining the singular, unless explicitly described to the contrary, it may be interpreted as the plural meaning. In the specification, the word "comprise" or "has" is used to specify existence of a feature, a number, a process, an operation, a constituent element, a part, or a combination thereof, and it will be understood that existence or additional possibility of one or more other features or numbers, processes, operations, constituent elements, parts, or combinations thereof are not excluded in advance.

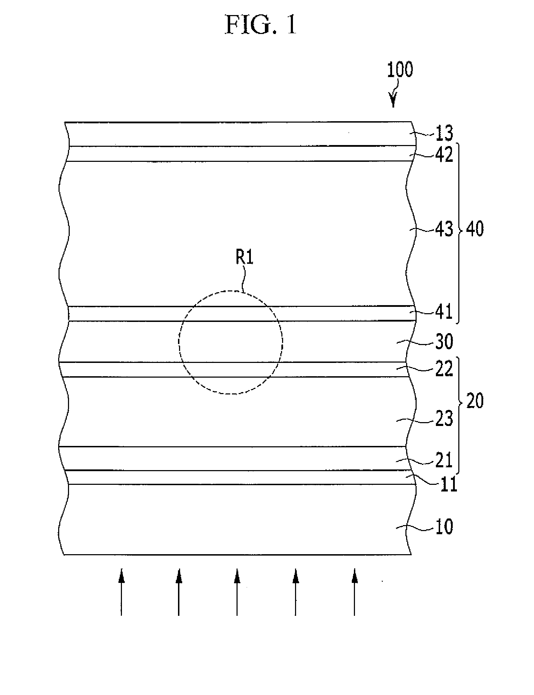

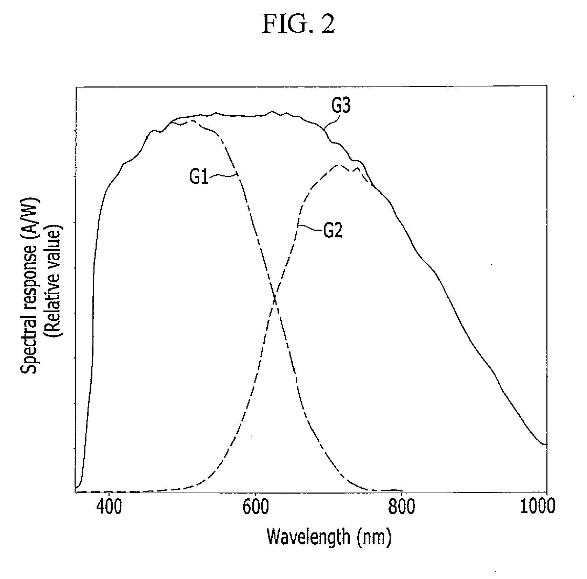

FIG. 1 illustrates a photoelectric conversion device according to an embodiment of the invention, and FIG. 2 illustrates a graph of a light absorption rate of first and second photoelectric conversion units according to a wavelength.

In FIG. 2, a first graph G1 shows light absorption of the first photoelectric conversion unit according to a wavelength, a second graph G2 shows light absorption of the second photoelectric conversion unit according to a wavelength, a the third graph G3 shows the sum of the first and second graphs G1 and G2.

In the embodiment of the invention shown in FIG. 1, the photoelectric conversion device 100 includes a substrate 10, a first electrode layer 11, first and second photoelectric conversion units 20 and 40, and a second electrode layer 13. The first electrode layer 11 is provided on the substrate 10, and the first and second photoelectric conversion units 20 and 40 are provided between the first electrode 11 and the second electrode 13.

For the first electrode layer 11, a transparent conductive layer, for example, transparent conductive oxide (TCO) such as tin oxide ($SnO_2$), indium tin oxide (ITO), zinc oxide (ZnO), and the like may be used. The second electrode layer 13 may be formed of a metallic material including, e.g., at least one of aluminum (Al), silver (Ag), gold (Au), cooper (Cu), platinum (Pt), and chromium (Cr).

As shown in FIG. 1, the first photoelectric conversion unit 20 is provided on the first electrode layer 11, and the second photoelectric conversion unit 40 is provided on the first photoelectric conversion unit 20. An intermediate unit 30 is disposed between the first and second photoelectric conversion units 20 and 40. For the purposes of this specification the first and second photoelectric conversion units and the intermediate unit non-exclusively define the principal components of a photoelectric conversion element.

The first photoelectric conversion unit 20 has a first energy bandgap, and the second photoelectric conversion unit 30 has a second energy bandgap. For example, the first photoelectric conversion unit may have an energy bandgap of 1.7 to 1.8 eV, and may absorb light having a short wavelength as shown in the first graph G1. The second photoelectric conversion unit 40 may have a smaller energy bandgap, e.g., 1.1 to 1.2 eV (relative to that of the first photoelectric conversion unit 20), and may absorb light of a long wavelength as shown in the second graph G2.

The two photoelectric conversion units 20 and 40 having different energy bandgaps are layered and may respectively absorb lights of different wavelength ranges so that the entire light absorption of the photoelectric conversion device 100 may be improved.

In the embodiment shown in FIG. 1, the first photoelectric conversion unit 20 includes a first type conductive layer 21, a first intrinsic silicon layer 23, and a second type conductive layer 22 sequentially layered on the first electrode layer. The first photoelectric conversion unit 20 may be formed of amorphous silicon. The first intrinsic silicon layer 23 may be formed of an amorphous silicon layer, and may be disposed between the first type conductive layer 21 and the second type conductive layer 22. The first type conductive layer 21 may be a p-type conductive layer formed to increase the number of holes by doping, e.g., boron (B), to the amorphous silicon. The second type conductive layer 22 may be an n-type conductive layer formed to increase the number of electrons by doping, e.g., phosphorus (P), to the amorphous silicon.

The first intrinsic silicon layer 23 includes electrons and holes that are the same in number or substantially the same in number to one another. When the first intrinsic silicon layer 23 receives light from an external source, silicon atoms that form the first intrinsic silicon layer 23 may absorb energy of the light. When the silicon atoms absorb light, the outermost electron of the silicon atom may be excited such that an electron-hole pair is formed. When the first type conductive layer 21 is biased to a negative electrode and the second type conductive layer 22 is biased to a positive electrode while the electron-hole pair is generated, the holes may move toward the first type conductive layer 21. Here, "biasing" refers to a suitable method for applying a direct current (DC) voltage to generate a constant current/voltage.

The first photoelectric conversion unit 20 may have a thickness of 0.5 $\mu$m or less. The photoelectric efficiency of the first intrinsic silicon layer 23 formed of amorphous silicon may not increase in proportion to an increase of the thickness thereof. Thus, the thickness of the first photoelectric conversion unit 20 may be to approximately 0.5 $\mu$m or less.

The second photoelectric conversion unit 40 includes a third type conductive layer 41, a second intrinsic silicon layer 43, and a fourth type conductive layer 42 sequentially layered on the intermediate unit 30. The second photoelectric conversion unit 40 may comprise crystalline silicon including a plurality of crystals. The third type conductive layer 41 may be a p-type conductive layer of which the number of holes is increased by doping, e.g., boron (B), to the crystalline silicon. In addition, the fourth type conductive layer 42 may be an n-type conductive layer of which the number of electrons is increased by doping, e.g., phosphorus (P), to amorphous or crystalline silicon.

The second intrinsic silicon layer 43 may be formed of a crystalline silicon layer. Crystals forming the crystalline silicon layer may have a diameter of less than 1 $\mu$m. The diameter of each crystal may be controlled according to RF power, a process pressure, or a $H_2/SiH_4$ flow ratio when forming layers through a plasma chemical vapor deposition method. Further, when the amorphous silicon is crystallized by performing a thermal treatment process thereof, the diameter of each crystal may be controlled by a process temperature of the thermal treatment process.

In this particular embodiment, the second intrinsic silicon layer 43 is thicker than the first intrinsic silicon layer 23.

A photoelectric effect mechanism of the first and second photovoltaic devices 20 and 40 will now be described in further detail. First, externally supplied light may enter to the first photoelectric conversion unit 20 (the light is indicated by upward-pointing arrows in FIG. 1). Then, the first intrinsic silicon layer 23 may absorb light of a short wavelength from the light and generate an electron-hole pair by generating a first photoelectric effect. In addition, light of a long wavelength, moving toward the second intrinsic silicon layer 43 rather than being absorbed in the first intrinsic silicon layer 23, may generate an electron-hole pair by generating a second photoelectric effect from the second intrinsic silicon layer 43.

Photo energy absorption of the first intrinsic silicon layer 23 (formed of amorphous silicon) may be, e.g., 3 to 10 times better than that of the second intrinsic silicon layer 43 (formed of crystalline silicon).

In the present embodiment, the intermediate unit 30 is disposed between the first and second photoelectric conversion units 20 and 40. The intermediate unit 30 may improve photoelectric efficiency of the first photoelectric conversion unit 20 formed of the amorphous silicon. The intermediate unit 30 may reflect a part of the light not absorbed by the first photoelectric conversion unit 20 so that the reflected light is directed back into the first photoelectric conversion unit 20. The intermediate unit 30 may have a plurality of layers, each having a smaller refractive index than that of the first photoelectric conversion unit 20.

In an example embodiment, the intermediate unit 30 includes a plurality of layers formed of a silicon-based material. For example, the intermediate unit 30 may include one or more layers formed of, e.g., $SiO_x$:H, $SiC_x$:H, and/or $SiN_x$:H.

The intermediate unit 30 may be formed using silane gas ($SiH_4$), carbon dioxide ($CO_2$), hydrogen gas ($H_2$), and phosphine gas ($PH_3$) or diborane gas ($B_2H_6$) as reaction gases. The intermediate unit 30 may be formed through a plasma chemical vapor deposition (CVD) method. The plasma CVD may use a $CO_2/SiH_4$ ratio in a range of 2 to 10 under a condition for manufacturing an uncrystallized layer, that is, a $H_2/SiH_4$ ratio. Plasma generation conditions may include a capacitively coupled parallel-plate electrode, a power frequency of 10 to 100 MHz, power density of 500 mW/cm$^2$, a pressure of 50 to 2000 Pa, and a substrate temperature of 150 to 250°C. Electrical conductivity of the intermediate unit 30 formed under such a condition may be increased as the refractive index is increased. Thus, when the refractive index is increased, the electrical conductivity of the intermediate unit 30 may be increased, and when the refractive index is decreased, the electrical conductivity of the intermediate unit 30 may be decreased.

The refractive index of the intermediate unit 30 preferably has an average refractive index that is smaller than the refractive index of the first photoelectric conversion unit 20 in order to partially reflect a part of the light output from the first photoelectric conversion unit 20 for re-entering to the first photoelectric conversion unit 20. However, when the average refractive index of the intermediate unit 30 is decreased, short-wavelength reflectivity may be increased. In this case, the light absorption of the first photoelectric conversion unit 20 may be increased as the electrical conductivity is decreased. Thus, a fill factor of the photoelectric conversion device 100 may be decreased, which may not improve photoelectric conversion efficiency. Therefore, the intermediate unit 30 may include at least one first intermediate layer 31 having a high refractive index and at least one second intermediate layer 32 having a low refractive index (i.e.., lower than that of the first intermediate layer 31). This may decrease the refractive index while supplementing the electrical conductivity of the intermediate unit 30.

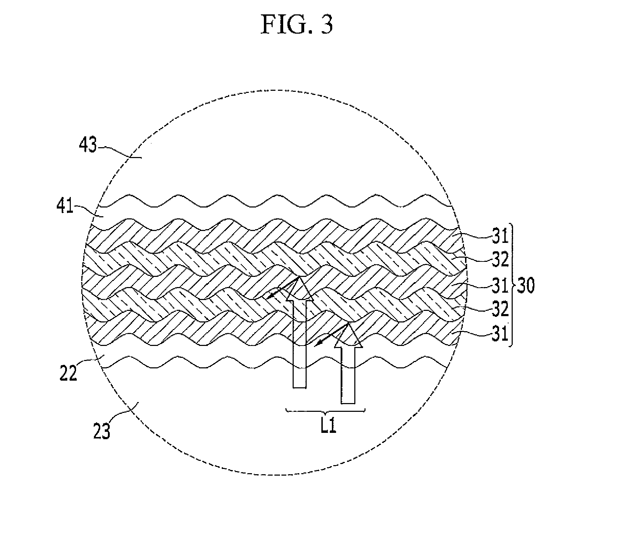

FIG. 3 illustrates an enlarged cross-sectional view of portion R1 in FIG..

In the embodiment shown in FIG. 3, the intermediate unit 30 includes at least one first intermediate layer 31 having a relatively high refractive index and at least one second intermediate layer 32 having a relatively low refractive index. The first intermediate layer 31 and the second intermediate layer 32 are alternately arranged, and may be formed of an n-type or p-type amorphous silicon oxide layer (n+ a-$SiO_x$ or p+ a-$SiO_x$), The n-type amorphous silicon oxide layer (n+ a-$SiO_x$) may be formed by doping with an impurity such as phosphorus (P), and the p-type amorphous silicon oxide layer (p+ a-$SiO_x$) may be formed by being doping with an impurity such as boron (B).

In an example embodiment the concentration of the impurities (dopants) in the first and second intermediate layers 31 and 32 may be less than 1 at%.

In the embodiment shown in FIG. 3, the intermediate unit 30 has a 5-layered structure including three first intermediate layers 31 and two second intermediate layers 32. The five intermediate layers may be respectively formed as the n-type amorphous silicon oxide layers (a-$SiO_x$).

The first intermediate layer 31 may have a refractive index in a range of 2.3 to 3.0, and the second intermediate layer 32 may a refractive index in a range of 1.6 to 2.1. Thus, a part of light L1 entering the intermediate unit 30 may be reflected to the first photoelectric conversion unit 20 due to a refractive index difference between the first and second intermediate layers 31 and 32. Thus, light absorption of the first photoelectric conversion unit 20 may be increased by reflection of light thereto.

The first intermediate layer 31 may have a higher crystallinity than the second intermediate layer 32. Thus, the first intermediate layer 31 may have a relatively high electrical conductivity. For example, the first intermediate layer 31 may have an electrical conductivity of above $10^{-3}$/Ωcm and the second intermediate layer 32 may have an electric conductivity of below $10^{-4}$/Ωcm.

One or more first intermediate layers 31 having the high electrical conductivity is disposed at the outermost portion(s) of the intermediate unit 30 so that they can respectively contact the first and second photoelectric conversion units 20 and 40. In further detail, among the first intermediate layers 31 having the high electrical conductivity, the intermediate layer 31 disposed in the lower outermost area of the intermediate unit 30 contacts the second type conductive layer (n-type conductive layer) of the first photoelectric conversion unit 20. The first intermediate layer 31 disposed in the upper outermost area of the intermediate unit 30 contacts the third type conductive layer (p-type conductive layer) of the second photoelectric conversion unit 40. As described, when the first intermediate layers 31 having the high electrical conductivity respectively contact the first and second photoelectric conversion units 20 and 40, the serial resistance of the photoelectric conversion device 100 may be increased and the fill factor may be improved.

In an implementation, the first intermediate layer 31 may have a thickness of 10 Å to 500 Å and the second intermediate layer 32 may have a thickness of 50 Å to 1500 A. For example, the first intermediate layer 31 may have a thickness of 50 A to 200 A and the second intermediate layer 32 may have a thickness of 50 Å to 200 Å.

The average refractive index $n_a$ of the intermediate unit 30 formed by alternately arranging the first intermediate layer 31 and the second intermediate layer 32 may satisfy Equation 1:

<Equation 1>

$$n_a = \frac{(n_1 \times d_1 + n_2 \times d_2 + ... + n_k \times d_k)}{(d_1 + d_2 + ... + d_k)}$$

Here, the intermediate unit 30 includes k layers (k may be an integer greater than 2), $n_1$, $n_l$...$n_k$ denote refractive indexes of the respective layers included in the intermediate unit 30, and $d_1$, $d_l$...$d_k$ denote a thickness of each layer included in the intermediate unit 30.

In an example embodiment, the intermediate unit 30 may be formed of three of the first intermediate layers 31 and two of the second intermediate layers 32. In this case, each of the first intermediate layers 31 may have a refractive index of 2.55, each of the second intermediate layers 32 may have a refractive index of 1.7, the lower outermost first intermediate layer and the upper outermost first intermediate layer may respectively have a thickness of 150 Å, and layers disposed between the lower outermost first intermediate layer and the upper outermost intermediate layer may respectively have a thickness of 100 Å. In this case, the intermediate unit 30 may have a thickness of 600 Å and may have an average refractive index of about 2.27 by Equation 1.

The intermediate unit 30 may have a thickness of less than 1000 Å, and the light reflecting capability of light having a short wavelength, reflected to the first photoelectric conversion unit 20 by the intermediate unit 30, may be represented by $\Delta n$ in Equation 2:

<Equation 2>

$$\Delta n = (n1 - n2) \times d$$

Here, n1 denotes a refractive index of the first photoelectric conversion unit 20, n2 denotes an average refractive index of the intermediate unit 30, and d represents a total thickness (x100 Å) of the intermediate unit 30.

Under such a condition, if it is assumed that the refractive index of the first photoelectric conversion unit 20 is 4, the light reflecting capability of the intermediate unit 30 according to the first embodiment was measured to be 10.4. The light reflecting efficiency of the intermediate unit 30 according to the first embodiment was similar to that of an intermediate unit 30 according to a comparative example. The intermediate unit 30 according to the comparative example is formed of a low refractive index layer having a refractive index of 1.9 and a thickness of 500 Å.

Table 1 shows photoelectric efficiency, an open voltage Voc, a fill factor FF, and a short-circuit current density Isc.

(Table 1)

|  | Photoelectric efficiency | Voc(V) | FF(%) | Isc(mA) |
|---|---|---|---|---|
| Comparative Example | 11.14 | 27.21 | 65.77 | 238.3 |
| First Example | 11.67 | 27.23 | 69.65 | 235.6 |

Referring to Table 1, the First Example (formed according to the first embodiment, and in which the first intermediate layer 31 had a high electrical conductivity) had a higher photoelectric efficiency than the Comparative Example. In further detail, the First Example had a photoelectric efficiency of 11.67% and the Comparative Example had photoelectric efficiency of 11.14%. In addition, the fill factor FF of the First Example was higher than that of the Comparative Example. Further, the Comparative Example had a fill factor of 65.77% and the First Example had a fill factor of 69.65%. Further, the open voltage Voc and the short-circuit current density Isc were similar to each other in the Comparative Example and the First Example.

From the above, it can be seen that the device according to the first embodiment had a light reflecting capability that is similar to the light reflecting capability of the Comparative Example, but the photoelectric efficiency and the fill factor FF of the device according to the first embodiment were higher than those of the Comparative Example.

As shown in FIG. 3, the surface of the intermediate unit 30 according to the present embodiment has an embossed structure for improvement of light scattering.

The refractive index of each layer included in the intermediate unit 30 may be controlled using a ratio of $CO_2/SiH_4$.

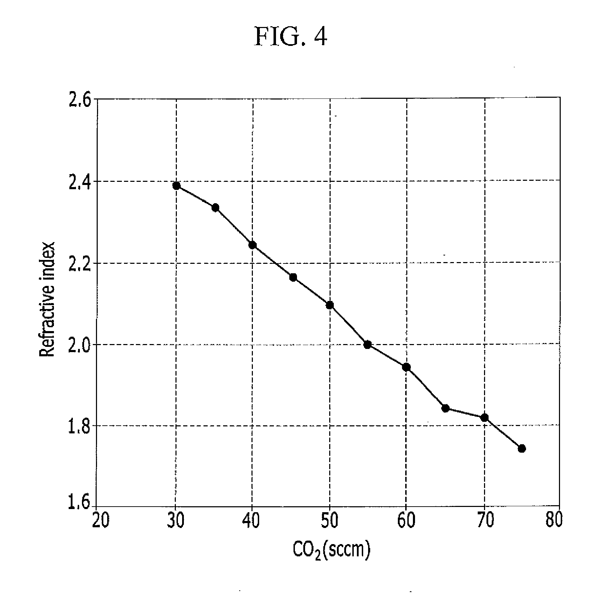

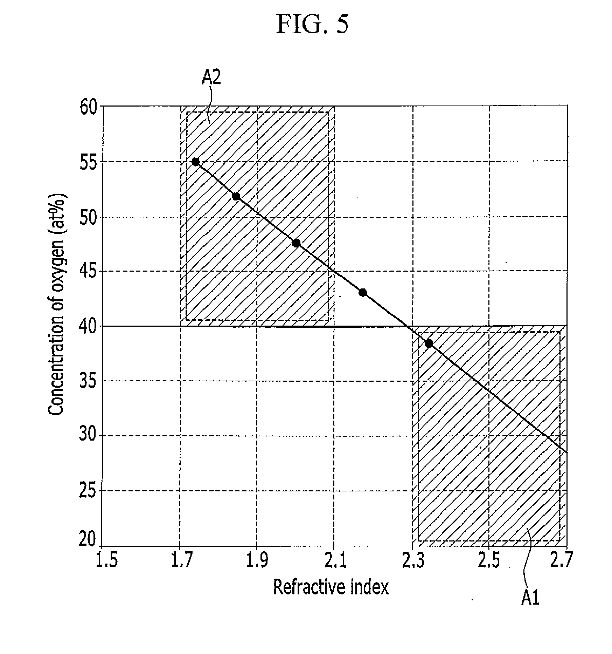

FIG. 4 illustrates a graph of variation of a refractive index according to amount of carbon dioxide, and FIG. 5 illustrates a graph of concentration of oxygen in the layer according to a refractive index.

In FIG. 4 and FIG. 5, a refractive index was measured with reference to light having a wavelength of 633 nm during a process for forming an intermediate unit 30 formed of a silicon oxide layer ($SiO_x$:H).

According to tjhis embodiment, a refractive index of each layer of the intermediate unit 30 may be controlled by changing the concentration of carbon dioxide ($CO_2$). Referring to FIG. 4, the refractive index was decreased when the amount of carbon dioxide $CO_2$ was increased under a plasma process condition for manufacturing the intermediate unit 30. Thus, the amount of carbon dioxide may be decreased to less than 35 sccm to form the first intermediate layer 31 having a refractive index of 2.3 to 3.0 (see A2 in FIG. 5), and the amount of carbon dioxide may be increased to 45 sccm to 70 sccm to form the second intermediate layer 32 having a refractive index of 1.7 to 2.1 (see A1 in FIG. 5).

The oxygen concentration (at%) in the intermediate unit 30 may be determined according to the amount of carbon dioxide. Thus, as shown in FIG. 5, decreases in the oxygen concentration (at%) are associated with increases in the refractive index.

In order to form the first intermediate layer 31 having a refractive index of 2.3 to 3.0, the concentration of oxygen in the layer is set to a value (e.g., a value less than 40 at%) included in a first area A1. In addition, in order to form the second intermediate layer 32 having a refractive index of 1.7 to 2.1, the concentration of oxygen in the layer is set to a value (e.g., 40 at% to 70 at%) included in a second area A2.

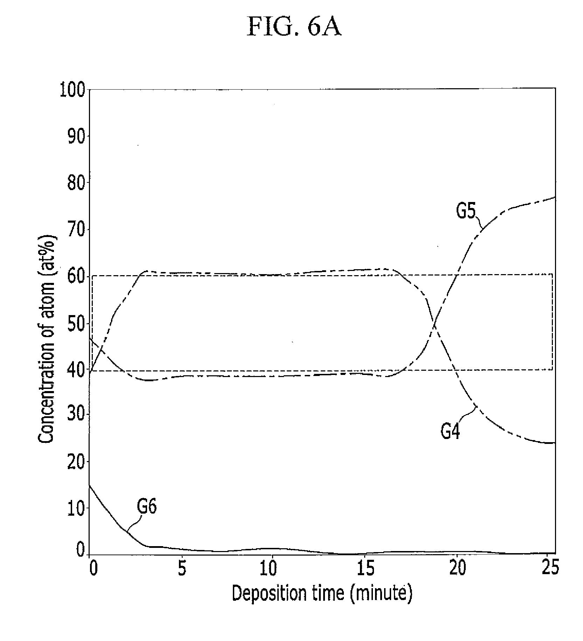

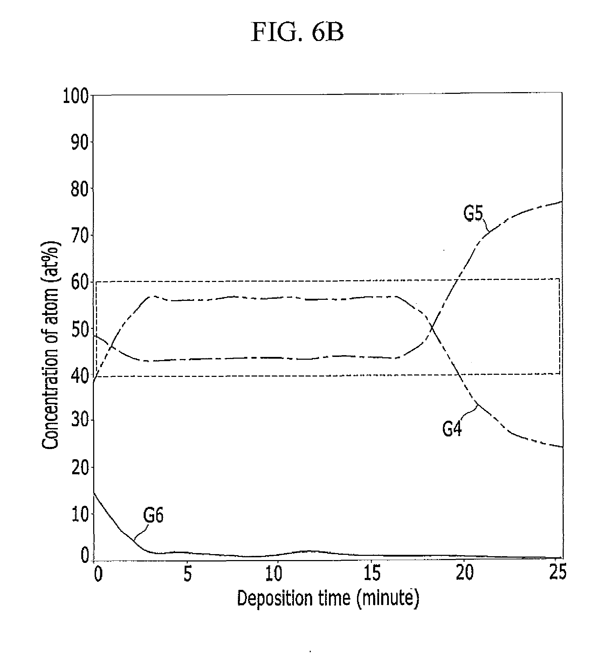

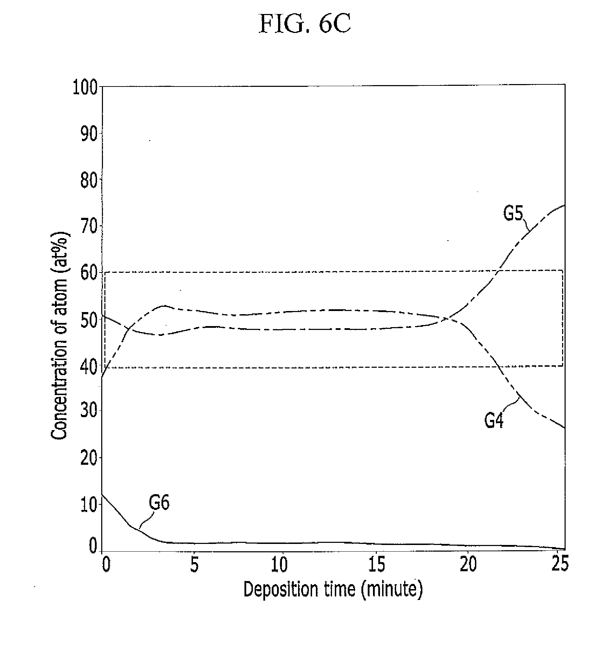

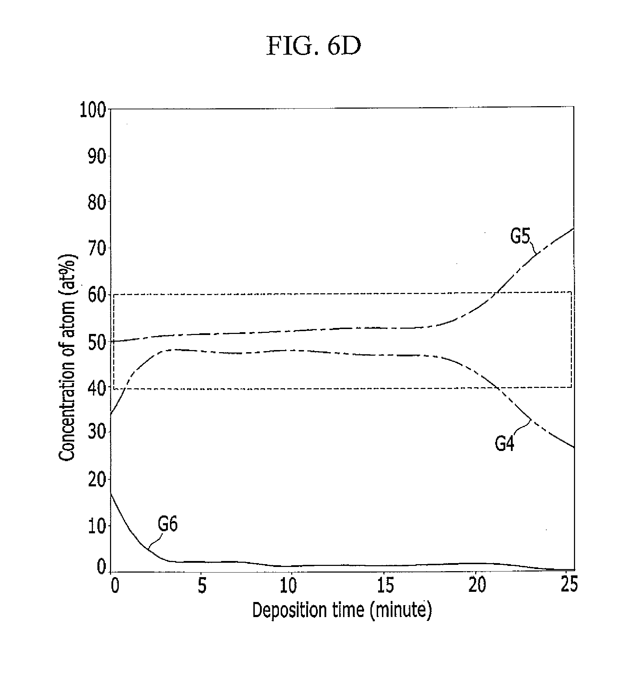

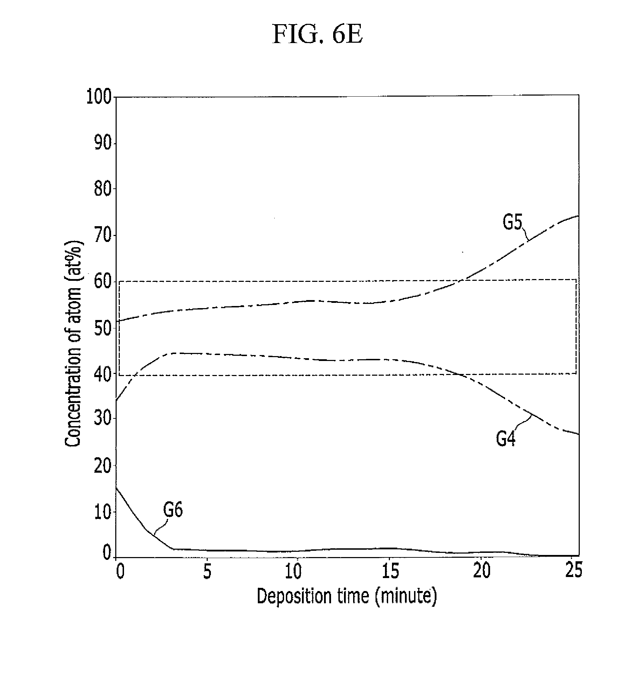

FIG. 6A to FIG. 6E illustrate graphs of atom concentrations (%) of oxygen ($O_{1s}$), carbon ($C_{1s}$), and silicon ($Si_{2p}$) according to deposition time, with each graph representing a different flow rate of carbon dioxide ($CO_2$). FIG. 6A illustrates a graph of atom concentration (at%) of oxygen ($O_{1s}$), carbon ($C_{1s}$), and silicon ($Si_{2p}$) when the amount of carbon dioxide ($CO_2$) is 35 sccm, FIG. 6B illustrates a graph of atom concentration (at%) of oxygen ($O_{1s}$), carbon ($C_{1s}$), and silicon ($Si_{2p}$) when the amount of carbon dioxide ($CO_2$) is 45 sccm, FIG. 6C illustrates a graph of atom concentration (at%) of oxygen ($O_{1s}$), carbon ($C_{1s}$), and silicon ($Si_{2p}$) when the amount of carbon dioxide ($CO_2$) is 55 sccm, FIG. 6D illustrates a graph of atom concentration (at%) of oxygen ($O_{1s}$), carbon ($C_{15}$), and silicon ($Si_{2p}$) when the amount of carbon dioxide ($CO_2$) 65 sccm, and FIG. 6E illustrates a graph of atom concentration (at%) of oxygen ($O_{1s}$), carbon ($C_{1s}$), and silicon ($Si_{2p}$) when the amount of carbon dioxide ($CO_2$) is 75 sccm.

In FIG. 6A to FIG. 6E, the fourth graph G4 represents the atom concentration (at%) of silicon ($Si_{2p}$), the fifth graph G5 represents the atom concentration (at%) oxygen ($O_{1s}$), and the sixth graph G6 represents the atom concentration (at%) of carbon ($C_{1s}$).

Referring to FIG. 6A to FIG. 6E, the oxygen concentration (at%) is increased as the flow rate of carbon dioxide ($CO_2$) is increased from 35 sccm to 75 sccm, but the silicon concentration (at%) is decreased.

When the amount of carbon dioxide ($CO_2$) is increased, the concentration (at%) of oxygen is increased over 40 at%. On the other hand, when the amount of carbon dioxide ($CO_2$) is decreased to be less than 35 sccm, the concentration (at%) of oxygen is decreased below 40 at%.

Therefore, the refractive index of each layer included in the intermediate unit 30 may be controlled by controlling the amount of carbon dioxide ($CO_2$) according to a deposition time.

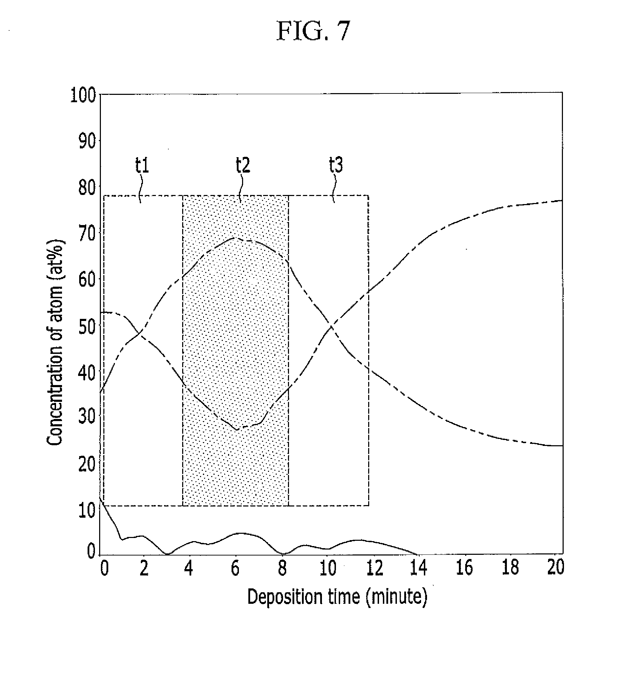

FIG. 7 illustrates a graph of oxygen concentration variation when forming an intermediate layer having a triple-layered structured.

The analysis illustrated in the graph of FIG. 7 was carried out by performing ion sputtering in a thickness direction using an X-ray photoelectron spectroscopy (XPS) method. It can be observed that a composition at the interface of the respective layers is gradually changed due to cross-contamination during the ion sputtering process.

Referring to FIG. 7, when the intermediate unit 30 having a three-layered structure in which the first intermediate layer 31 having a thickness of 100 Å and the second intermediate layer 32 having a thickness of 100 Å are sequentially layered is formed, the oxygen concentration was decreased from 55 at% to 30 at% for about 6 minutes after deposition was started, and then the oxygen concentration was gradually increased from after 6 minutes to 10 minutes.

Thus, the intermediate unit 30 was formed of the three-layered structure through variation of the oxygen concentration (at%). That is, the second intermediate layer 32 was formed during a first period t1, the first intermediate layer 31 was formed during a second period t2, and the second intermediate layer 32 was formed again during a third period t3.

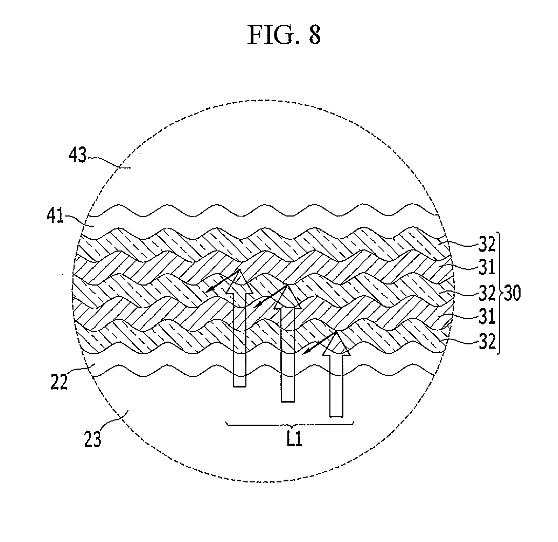

FIG. 8 illustrates a cross-sectional view of a structure of an intermediate layer according to a second embodiment of the invention.

Referring to FIG. 8, an intermediate unit 30 according to the second embodiment has a five-layered structure in which a first intermediate layer 31 having a high refractive index and a second intermediate layer 2 having a low refractive index are alternately arranged. Here, the second intermediate layer directly contacts first and second photoelectric conversion units 20 and 40 by being disposed at the outermost areas of the intermediate unit 30.

In the embodiment shown in FIG. 8, the number of second intermediate layers 32 in the intermediate unit 30 is greater than the number of first intermediate layers 31. Light L1 entering the intermediate unit 30 is partially reflected to the first photoelectric conversion unit 20 due to a refractive index difference between the second intermediate layer 32 and the first intermediate layer 31. In particular, when the number of second intermediate layers 32 is greater than the number of first intermediate layers 31, reflex efficiency of the incident light L1 may be improved compared to when the number of first intermediate layers 31 is greater than the number of second intermediate layers 32, and accordingly, light absorption of the first photoelectric conversion unit 20 may be increased.

The first intermediate layer 31 is disposed at the outermost edge of the intermediate unit 30 as in the first embodiment so as to decrease the serial resistance of the intermediate unit 30 or improve contact resistance.

FIG. 3 and FIG. 8 illustrate that the intermediate unit 30 has the five-layered structure, but the intermediate unit 30 may have, e.g., a double-layered, triple-layered, four-layered, or more layered structure.

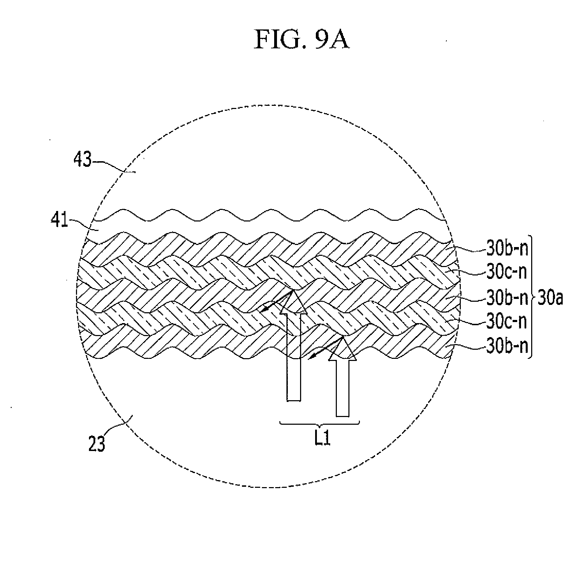

FIG. 9A to FIG. 9D illustrate cross-sectional views of photoelectric conversion devices according to other embodiments of the invention.

Referring to FIG. 9A, an intermediate unit 30a according to a third embodiment of the invention has a five-layered structure in which a first n-type intermediate layer 31-n having a high refractive index and a second n-type intermediate layer 32-n having a low refractive index are alternately arranged. Here, the first n-type intermediate layers 31-n disposed in the outermost sides of the intermediate unit 30a directly contact the first and second photoelectric conversion units 20 and 40.

When the first n-type intermediate layer 31-n is formed of an amorphous silicon oxide layer (n+ a-SiO$_x$), the second type conductive layer 22 (see FIGS. 1 and 3) may be omitted in the first photoelectric conversion unit 20. Therefore, the first n-type intermediate layer 31-n disposed in the outermost side of the intermediate unit 30a may directly contact the first intrinsic silicon layer 23 of the first photoelectric conversion unit 20.

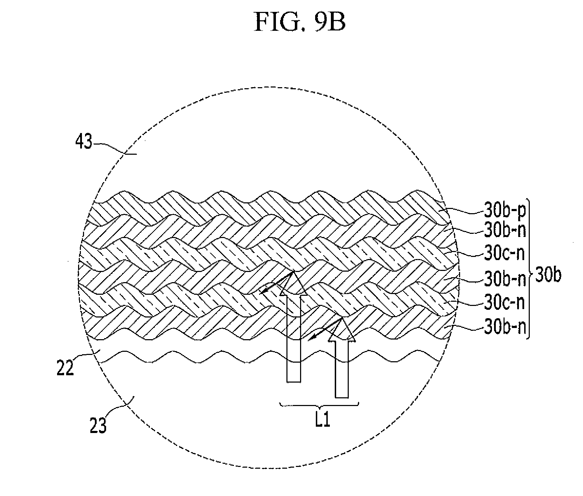

Referring to FIG. 9B, an intermediate unit 30b according to a fourth embodiment of the invention has a six-layered structure in which the first n-type intermediate layer 31-n having a high refractive index, the second n-type intermediate layer 32-n having a low refractive index, and a first p-type intermediate layer 31-p having a high refractive index are alternately arranged. Here, the first n-type intermediate layer 31-n is provided in the lowermost side of the intermediate unit 30b and thus directly contacts the first photoelectric conversion unit 20, and the first p-type intermediate layer 31-p is provided in the uppermost side of the intermediate unit 30b and thus directly contacts the second photoelectric conversion unit 40.

When the first p-type intermediate layer 31-p is formed of a p-type amorphous silicon oxide layer (p+ a-SiO$_x$), the third type conductive layer 41 (see FIGS. 1 and 3) may be omitted in a second photoelectric conversion unit 40. Therefore, the first p-type intermediate layer 31-p disposed in the outermost side of the intermediate unit 30b may directly contact the second intrinsic silicon layer 43 of the second photoelectric conversion unit 40.

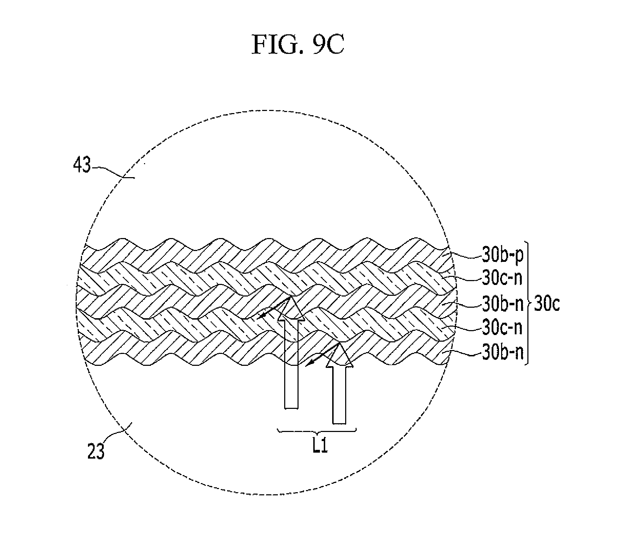

Referring to FIG. 9C, an intermediate unit 30c according to a fifth embodiment of the invention has a five-layered structure including the first n-type intermediate layer 31-n having a high refractive index, the second n-type intermediate layer 32-n having a low refractive index, and the first p-type intermediate layer 31-p having a high refractive index. Here, the first n-type intermediate layer 31-n is provided in the lowermost side of the intermediate unit 30c and thus directly contacts the first photoelectric conversion unit 20, and the first p-type intermediate layer 31-p is provided in the uppermost side of the intermediate unit 30c and thus directly contacts the second photoelectric conversion unit 40.

When the first p-type intermediate layer 31-p is formed of a p-type amorphous silicon oxide layer (p+ a-SiO$_x$), a second type conductive layer 41 may be omitted in the second photoelectric conversion unit 40. Therefore, the first p-type intermediate layer 31-p disposed in the outermost side of the intermediate unit 30c may directly contact the second intrinsic silicon layer 43 of the second photoelectric conversion unit 40. In addition, when the first n-type intermediate layer 31-n of the intermediate unit 30c is formed of an n-type amorphous silicon oxide (n+ a-SiO$_x$), the second type conductive layer 22 (see FIGS. 1 and 3) may be omitted in the first photoelectric conversion unit 20. Therefore, the first n-type intermediate layer 31-n disposed in the outermost side of the intermediate unit 30c may directly contact the first intrinsic silicon layer 23 of the first photoelectric conversion unit 20.

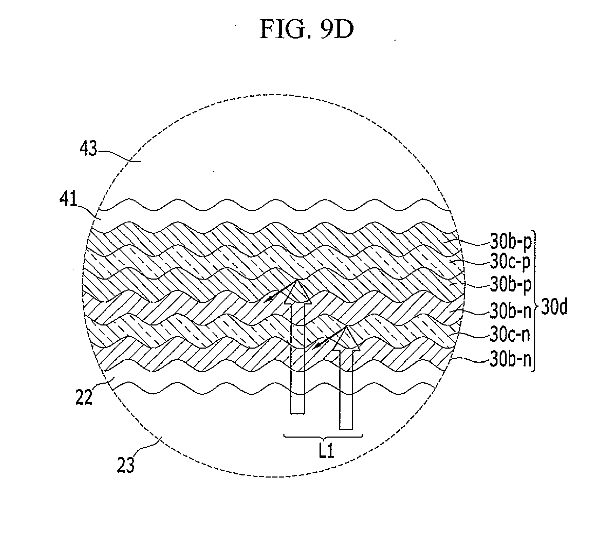

Referring to FIG. 9D, an intermediate unit 30d according to a sixth embodiment of the invention has a six-layered structure including the first n-type intermediate layer 31-n having a high refractive index, the first p-type intermediate layer 31-p having a high refractive index, the second n-type intermediate layer 32-n having a low refractive index, and a second p-type intermediate layer 32-p having a low refractive index.

Here, the upper three layers among the six layers of the intermediate unit 30d may be formed of p-type intermediate layers (i.e., the first p-type intermediate layer 31-p and the second p-type intermediate layer 32-p) and the lower three layers may be formed of n-type intermediate layers (i.e., the first n-type intermediate layer 31-n and the second n-type intermediate layer 32-n).

For example, the n-type intermediate layer 31-n may be provided in the lowermost side of the intermediate unit 30d and thus directly contact the first photoelectric conversion unit 20, and the first p-type intermediate layer 31-p may be provided in the uppermost side of the intermediate unit 30d and thus directly contact the second photoelectric conversion unit 40. In addition, the first p-type intermediate layer 31-p may be provided in the lowermost side of the upper three layers, the first n-type intermediate layer 31-n may be provided in the uppermost side of the lower three layers, and a P-N junction may be formed at a junction of the upper three layers and the lower three layers.

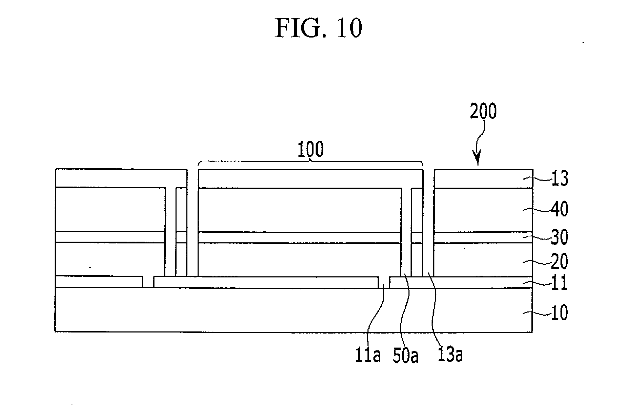

FIG. 10 illustrates a cross-sectional view of a photoelectric conversion device including a plurality of photoelectric conversion cells according to an embodiment of the invention.

Referring to FIG. 10, a photoelectric conversion device 200 includes the substrate 10 having a plurality of cell areas. A plurality of the photoelectric conversion cells 100 are provided on the substrate 10 respectively corresponding to the plurality of cell areas.

The plurality of photoelectric conversion cells 100 are coupled in series. Each photoelectric conversion cell 100 has a structure that is similar to the photoelectric conversion element shown in FIG. 1 and, as shown in FIG. 10, has a via hole 50a for serial connection with its neighboring cell.

In further detail, each of the photoelectric conversion cells 100 includes the first electrode layer 11, the first and second photoelectric conversion units 20 and 40 sequentially layered on the first electrode layer 11 and absorbing externally supplied light, and the second electrode layer 13 provided on the second photoelectric conversion unit 40.

The intermediate unit 30 is provided between the first and second photoelectric conversion units 20 and 40 to improve photoelectric efficiency of the first photoelectric conversion unit 20. The intermediate unit 30 is as described above in accordance with of the invention.

The first electrode layer 11 is divided into cell area units by a first separation groove 11 a, and the first and second photoelectric conversion units 20 and 40, the intermediate unit 30, and the second electrode layer 13 are divided into cell area units by a second separation groove 13a. The first and second separation grooves 11a and 13a may be formed through, e.g., a laser process.

The via hole 50a may be formed by patterning the first photoelectric conversion unit 20, the intermediate unit 30, and the second photoelectric conversion unit 40, e.g., through the laser process, to expose the first electrode layer 11 of its neighboring photoelectric conversion cell. Therefore, the second electrode layer 13 may be electrically connected to the first electrode layer 11 of the neighboring photoelectric conversion cell through the via hole 50a, With such a method, the plurality of photoelectric conversion cells 100 may be coupled in series.

By way of summation and review, a photoelectric conversion device according to the invention may employ a layered-type structure in which two or more photoelectric conversion layers respectively having different energy bandgaps are layered to improve photoelectric efficiency. The photoelectric conversion device may be provided with the photoelectric conversion layers to absorb energy from externally supplied light to generate photoelectric effect. The photoelectric conversion layers may generate a photoelectric effect by absorbing energy from light, and generate a free electron from the photoelectric effect to thereby generate a current.

Embodiments of the invention may therefore provide a photoelectric conversion device that can improve photoelectric efficiency relative to the prior art. As described above, the intermediate unit may be formed of at least one first intermediate layer (having a first refractive index) and at least one second intermediate layer (alternately arranged with the at least one first intermediate layer, and having a second refractive index that is smaller than the first refractive index) so that the photoelectric efficiency of the first photoelectric conversion unit may be improved.

Embodiments of the invention have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

**Claims**

1. A photoelectric conversion element, comprising:

   a first photoelectric conversion unit on a substrate and having a first energy bandgap;
   a second photoelectric conversion unit having a second energy bandgap that is different from the first energy bandgap, the second photoelectric conversion unit being on the first photoelectric conversion unit; and
   an intermediate unit between the first and second photoelectric conversion units, the intermediate unit including a stack of a first intermediate layer and a second intermediate layer, each of the first intermediate layer and the second intermediate layer having a refractive index that is smaller than that of the first photoelectric conversion unit, the first intermediate layer having a first refractive index, and the second intermediate layer having a second refractive index that is smaller than the first refractive index.

2. An element as claimed in claim 1, wherein the intermediate unit includes at least one first intermediate layer in the stack, and includes at least one second intermediate layer alternately arranged with the first intermediate layer in the stack.

3. An element as claimed in claim 1 or 2, wherein the first intermediate layer has an electrical conductivity that is higher than that of the second intermediate layer.

4. An element as claimed in claim 3, wherein:

the first and second intermediate layers are doped with an n-type or p-type impurity, and
concentrations of the n-type and p-type impurities in the first and second intermediate layers are respectively less than 1 at%.

5. An element as claimed in claim 3, wherein:

the first and second intermediate layers are respectively doped with an n-type or p-type impurity, and
two n-type or p-type first intermediate layers are respectively disposed at outermost sides of the intermediate unit, such that the first photoelectric conversion unit is in direct contact with one of the two n-type or p-type first intermediate layers, and the second photoelectric conversion unit is in direct contact with another of the two n-type or p-type first intermediate layers.

6. An element as claimed in claim 5, wherein:

the first photoelectric conversion unit includes a first intrinsic silicon layer formed of amorphous silicon, a first type conductive layer disposed between the first intrinsic silicon layer and the substrate, and a second type conductive layer provided on the first intrinsic silicon layer, and
the second photoelectric conversion unit includes a second intrinsic silicon layer formed of crystalline silicon including a plurality of crystals, a third type conductive layer disposed between the second intrinsic silicon layer and the intermediate unit, and a fourth type conductive layer provided on the second intrinsic silicon layer.

7. An element as claimed in claim 3, wherein:

the first and second intermediate layers are respectively doped with an n-type or p-type impurity, and
an n-type first intermediate layer and a p-type first intermediate layer are respectively disposed at outermost sides of the intermediate unit, the first photoelectric conversion unit being in direct contact with one of the n-type first intermediate layer and the p-type first intermediate layer, and the second photoelectric conversion unit being in direct contact with another of the n-type first intermediate layer and the p-type first intermediate layer.

8. An element as claimed in claim 7, wherein:

the first photoelectric conversion unit includes a first intrinsic silicon layer formed of amorphous silicon and contacting the n-type first intermediate layer, and
the second photoelectric conversion unit includes a second intrinsic silicon layer formed of crystalline silicon including a plurality of crystals and contacting the p-type first intermediate layer.

9. An element as claimed in claim 3, wherein:

the first and second intermediate layers are doped with an n-type or p-type impurity, and
the first and second intermediate layers include at least one of $SiO_x:H$, $SiC_x:H$, and $SiN_x:H$.

10. An element as claimed in any preceding claim, wherein the first intermediate layer has a refractive index in a range of 2.3 to 3.0 and the second intermediate layer has a refractive index in a range of 1.6 to 2.1.

11. An element as claimed in claim 10, wherein the first intermediate layer has an electrical conductivity of over $10^{-3}/\Omega cm$ and the second intermediate layer has an electrical conductivity of below $10^{-4}/\Omega cm$.

12. An element as claimed in claim 10 or 11, wherein the first intermediate layer has a thickness of 10 Å to 500 Å and the second intermediate layer has a thickness of 50 Å to 1500 Å.

13. An element as claimed in claim 10, 11 or 12, wherein the first intermediate layer has an oxygen concentration of below 40 at% and the second intermediate layer has an oxygen concentration of 40 at% to 70 at%.

**14.** An element as claimed in any preceding claim, wherein the intermediate unit includes k layers, where k is an integer greater than 2, the refractive index of the intermediate unit being defined as $n_a$ according to the following equation,

$$n_a = \frac{(n_1 \times d_1 + n_2 \times d_2 + ... + n_k \times d_k)}{(d_1 + d_2 + ... + d_k)}$$

in which $n_l$ to $n_k$ denote a refractive index of each of the k layers included in the intermediate layer, and $d_l$ to $d_k$ denote a thickness of each of the k layers included in the intermediate unit.

**15.** An element as claimed in claim 1, wherein the intermediate unit has a refractive index of 1.7 to 2.5 and has a thickness of 100 Å to 1500 Å.

**16.** A photoelectric conversion device, comprising:

a substrate having a plurality of cell areas; and
a plurality of photoelectric conversion cells on the substrate, respectively corresponding to the plurality of cell areas, the photoelectric conversion cells being coupled in series and each including:

a first electrode layer on the substrate;
a photoelectric element according to any preceding claim; and
a second electrode layer on the second photoelectric conversion unit.

**17.** A device as claimed in claim 16, wherein:

the first electrode layer is divided into the cell areas by a first separation groove, and
the first and second photoelectric conversion units, the intermediate unit, and the second electrode layer are divided into the cell areas by a second separation groove.

**18.** A device as claimed in claim 17, wherein, in each photoelectric conversion cell, a via hole sequentially penetrates the second photoelectric conversion unit, the intermediate unit, and the first photoelectric conversion unit to expose a first electrode layer of a neighboring photoelectric conversion cell, and the second electrode layer is electrically connected to the first electrode layer of the neighboring photoelectric conversion cell through the via hole.

**19.** A device as claimed in claim 17, wherein:

a via hole is provided in a first photoelectric conversion cell of the plurality of photoelectric conversion cells, the via hole sequentially penetrating the second photoelectric conversion unit, the intermediate unit, and the first photoelectric conversion unit of the first photoelectric conversion cell, the via hole exposing a first electrode layer of a second photoelectric conversion cell of the plurality of photoelectric conversion cells, the second photoelectric conversion cell neighboring the first photoelectric conversion cell, and
the second electrode layer of the first photoelectric conversion cell is electrically connected to the first electrode layer of the second photoelectric conversion cell through the via hole.

FIG. 1

FIG. 2

FIG. 3

FIG. 4

FIG. 5

FIG. 6A

## FIG. 6B

FIG. 6C

# FIG. 6D

## FIG. 6E

# FIG. 7

FIG. 8

# FIG. 9A

## FIG. 9B

43

30b-p
30b-n
30c-n
30b-n
30c-n
30b-n

30b

22

23

L1

FIG. 9C

## FIG. 9D

43
41
30b-p
30c-p
30b-p
30b-n 30d
30c-n
30b-n
22
23
L1

# FIG. 10